# FASCICULE DE BREVET EUROPEEN

(11) **EP 2 236 864 B1**
(45) Date de publication et mention de la délivrance du brevet: **05.10.2011**
(21) Numéro de dépôt: 10305267.6
(22) Date de dépôt: 18.03.2010
(51) Int. Cl.: F16J 15/08, B23K 1/00, B23K 1/008, H01L 21/60, F16L 23/20

(54) **Joint métallique à lèvres et machine équipée d'un tel joint**
Metalllippendichtung und mit einer solchen Dichtung ausgestattete Maschine
Metal lip seal and machine equipped with such a seal

(30) Priorité: 30.03.2009 FR 0951955
(43) Date de publication de la demande: 06.10.2010
(73) Titulaire: Commissariat à l'Énergie Atomique et aux Énergies Alternatives, 75015 Paris (FR)
(72) Inventeur: Marion, François, 38950 Saint-Martin le Vinoux (FR)
(74) Mandataire: Vuillermoz, Bruno

(56) Documents cités:
- EP-A- 0 795 891
- FR-A1- 2 562 630
- US-A- 4 502 663
- US-A1- 2005 248 095

## Description

### DOMAINE TECHNIQUE

L'invention se rapporte au domaine des joints métalliques à lèvre, aptes à assurer une étanchéité notamment à température élevée et sous atmosphère contrôlée. Elle s'inscrit plus spécifiquement dans le cadre de la réalisation de l'hybridation de composants électroniques ou électro-optiques en vue de la réalisation de détecteurs.

### ETAT ANTERIEUR DE LA TECHNIQUE

Dans les machines utilisant des chambres à atmosphère contrôlée, l'étanchéité de ces chambres peut être assurée par des joints pour maintenir la pression désirée à l'intérieur de ces chambres.

Par exemple, dans le document US 5,968,389, il est décrit une installation d'hybridation permettant de souder un composant sur un substrat à l'aide de microbilles. Cette installation met en oeuvre une cloche, à l'intérieur de laquelle une atmosphère contrôlée est établie, pour assurer les déplacements verticaux d'un ensemble formé par le substrat, les microbilles et le composant, ledit ensemble pouvant ainsi être mis en contact ou non avec la sole chauffante d'un four, tout en limitant les causes de désalignement du composant par rapport au substrat. Plus précisément, le maintien étanche du substrat contre l'extrémité de la partie inférieure de la cloche est réalisé par dépression ménagée sur la périphérie du substrat.

L'ensemble formé par le substrat, le composant et les microbilles peut ainsi être déplacé et notamment être maintenu découplé de la sole le temps, par exemple, du préchauffage de la sole à la température de fusion des microbilles.

Le substrat peut être muni en périphérie d'un joint venant en contact avec la partie inférieure de la cloche en contact avec le substrat, pour assurer l'herméticité de la chambre intérieure sous atmosphère contrôlée. En outre, le joint permet de compenser les défauts de parallélisme pouvant exister entre le substrat et la partie inférieure de la cloche.

Dans les installations utilisées dans le domaine de l'industrie des semi-conducteurs, telles que les machines à gravure plasma ou les machines de dépôt sous vide, il est connu d'utiliser des joints réalisés dans des polymères souples (par exemple joint de marque Kalrez^{®} ou Perlast^{®}) pour obtenir un bon écrasement et une surface de contact maximisée entre le joint et l'élément à maintenir étanche.

Cependant, la température d'utilisation de ces joints est limitée à 330°C pour des expositions de 30 à 300 secondes à de telles températures, et dans tous les cas, ces joints ne peuvent supporter des températures supérieures à 330°C.

Or dans certaines applications, comme celles décrites ci-dessus, le substrat portant le composant étant mis en contact avec la sole préchauffée, la montée en température par transfert thermique est extrêmement rapide. Le substrat, ainsi que le joint sont donc rapidement soumis à une température élevée qui peut atteindre 400°C, voire 500°C.

Une solution à ce problème pourrait consister à utiliser un joint métallique en forme de tube torique. Cependant, cette solution n'est efficace que lorsqu'il est possible de serrer mécaniquement le joint, c'est-à-dire d'imposer une force suffisante pour assurer le contact du joint avec la partie inférieure de la paroi pour permettre au joint d'épouser la forme de la cloche.

Il est également possible d'utiliser des joints toriques munis de ressort (par exemple des joints à ressort de type Tamshell^{®}), ledit ressort étant intégré au sein du tore, pour augmenter la force de contact du joint avec la cloche, tout en conservant les propriétés de souplesse du joint afin de permettre au joint d'épouser les défauts de planéité.

Cependant, l'utilisation de tels joints à ressort requiert une force d'appui permettant notamment l'écrasement du joint sur la cloche, supérieure à 60 Newtons par millimètre linéaire de joint pour assurer par exemple l'étanchéité au vide, cette force d'appui minimum étant notamment nécessaire pour écraser le joint de 20% afin qu'il épouse la forme de la partie inférieure de la cloche et assure une bonne étanchéité.

Or dans certaines applications, et notamment dans celles décrites précédemment, la force d'appui de la cloche n'excède pas 5 Newtons par millimètre. La solution précédemment présentée n'est donc pas adaptée pour assurer un niveau de compression du joint suffisant dans le cas d'une mise en pression du joint autoentretenu par le vide. En effet, le joint ne s'écrasera pas suffisamment pour permettre d'établir un vide correct dans la cloche.

En outre, l'un des inconvénients liés à l'utilisation de joints travaillant en contrainte réside dans le fait que la surface de contact du joint avec les parois de la cloche est réduite, et ne permet pas au joint d'épouser la forme de la partie inférieure de la cloche, et partant, ne garantit pas l'herméticité requise.

Dans ce contexte, la présente invention a pour but de proposer un joint métallique à lèvres exempt de l'une au moins des limitations précédemment évoquées. Plus particulièrement, la présente invention vise notamment à trouver une solution apte à assurer l'herméticité d'une pièce, résistante à des températures élevées, allant notamment jusqu'à 400°C voire 500°C, apte à assurer une bonne herméticité même avec une force d'appui n'excédant pas 60 newtons par millimètre, et offrant une grande surface de contact.

### EXPOSE DE L'INVENTION

A cet effet, l'invention a pour objet un dispositif de joint métallique à lèvres, apte à assurer l'étanchéité entre deux éléments, selon la revendication 1. Selon l'invention, ce joint comprend :
- deux organes élastiques destinés à être logés chacun dans une cavité de l'un des deux éléments, lesdites cavités étant situées à l'aplomb d'une zone de coopération des deux éléments entre eux au niveau de laquelle l'étanchéité est recherchée ; et
- un corps flexible solidarisé à l'élément recevant les organes élastiques, pourvu de deux extrémités libres, lesdites extrémités libres s'étendant au moins à l'aplomb desdites zones de coopération et étant en contact avec les organes élastiques.

Selon l'invention, chacun des organes élastiques est apte à exercer une force de contact sur les extrémités libres pour assurer une étanchéité entre les deux éléments.

En d'autres termes, pour assurer l'étanchéité entre les premier et deuxième éléments, notamment d'une enceinte, l'invention propose d'utiliser des organes élastiques et un corps flexible fixés au premier élément, le corps flexible n'étant pas déformé dans sa masse, sa déformation n'étant induite que par les organes élastiques.

Ainsi, en position de travail, c'est-à-dire lorsque le joint doit assurer une étanchéité, la force d'appui, qui peut être la résultante d'une différence de pression, peut être telle que les extrémités libres (ou lèvres) dudit joint peuvent être rendues quasi tangentes à la surface de la zone de coopération au niveau de laquelle l'étanchéité est recherchée. L'invention propose ainsi d'utiliser un organe annexe pour exercer localement une force de contact pour conserver le joint à plat et augmenter ainsi la surface de contact du joint.

On dispose ainsi d'un joint double lèvres apte par exemple à assurer l'herméticité de deux chambres.

Le corps flexible peut être constitué par une lame métallique ou présenter une forme annulaire, typiquement une rondelle percée en son centre.

S'il se présente sous forme annulaire, le corps flexible peut être solidarisé sur l'élément recevant les organes élastique par sa partie centrale, et les extrémités libres peuvent être formées par les bords diamétralement opposés par rapport au point de fixation centrale.

Chacun des organes élastiques peut être constitué par un ressort torique.

Avantageusement, la solidarisation du corps flexible à l'un des éléments est réalisée par collage, soudure, ou vissage. Suivant le moyen de fixation utilisé, le corps flexible peut être démontable ou non démontable hors dudit élément recevant les organes élastiques.

L'invention a également pour objet un dispositif d'hybridation de composants par billes de soudure selon la revendication 6, comprenant au moins :
- un bloc supérieur comprenant une chambre intérieure apte à recevoir un composant à hybrider sur une plaque support à l'aide de microbilles de soudure, et une chambre extérieure en périphérie de la chambre intérieure et séparée de cette dernière par une paroi interne au bloc supérieur, et une paroi externe en périphérie de la chambre extérieure ;
- des moyens pour amener la plaque support en contact thermique avec un élément chauffant, après que l'élément chauffant ait atteint une certaine température de fusion ;
- des moyens pour découpler la plaque support de l'élément chauffant, après chauffage du substrat.

Selon l'invention, la plaque support est munie d'un joint tel que décrit ci-dessus, les organes élastiques dudit joint étant logés chacun dans une cavité ménagée au sein de ladite plaque support, la portion solidarisée du corps flexible étant située en regard de la chambre extérieure, et lesdites extrémités libres du corps flexible étant positionnées en regard, respectivement de ladite paroi interne et de la paroi externe au niveau desquelles l'étanchéité est recherchée.

En d'autres termes, en position de travail, les extrémités libres du joint sont plaquées contre la plaque support, qui peut être constituée par un substrat, et seuls les organes élastiques exercent une force de contact sur lesdites extrémités libres pour assurer l'étanchéité du bloc supérieur. En rendant ces extrémités libres parallèles à la surface de contact de la plaque support avec le bloc supérieur, l'étanchéité est facilitée et la surface de contact est maximalisée.

L'invention permet ainsi d'assurer l'herméticité d'une première zone, ici la chambre extérieure, mais également de créer une deuxième zone hermétique, ici la chambre intérieure.

Avantageusement, lesdites extrémités libres subissent une force d'appui, respectivement de la paroi interne et de la paroi externe inférieure à 60 Newtons par millimètre linéaire de joint. Ces forces d'appui résultent au moins d'une différence de pression entre les chambres intérieure et extérieure ou entre la chambre extérieure et la pression de l'environnement dans lequel se trouve ledit dispositif.

Selon un mode de réalisation, la chambre intérieure est sous vide.

Selon un autre mode de réalisation, la chambre intérieure est placée sous atmosphère contrôlée et la chambre extérieure est sous vide.

### BREVE DESCRIPTION DES DESSINS

D'autres caractéristiques et avantages de l'invention ressortiront clairement de la description qui suit, à titre indicatif et nullement limitatif, en référence aux dessins annexés, dans lesquels :
- la figure la est une représentation schématique d'un joint double lèvres vue de dessus selon un mode de réalisation de l'invention ;
- la figure 1b est une représentation schématique d'un joint double lèvres vue de dessus selon un autre mode de réalisation de l'invention ;
- la figure 2 est une vue en section d'un joint double lèvres selon la figure 1a ou 1b ;
- la figure 3 est une représentation schématique partielle d'une installation munie d'un joint double lèvres avant contact avec le bloc supérieur de ladite installation selon un mode de réalisation de l'invention ;
- La figure 4 est une représentation schématique partielle d'une installation munie d'un joint double lèvres après contact avec le bloc supérieur de ladite installation selon un mode de réalisation de l'invention.

### EXPOSE DETAILLE DE MODES DE REALISATION PARTICULIER

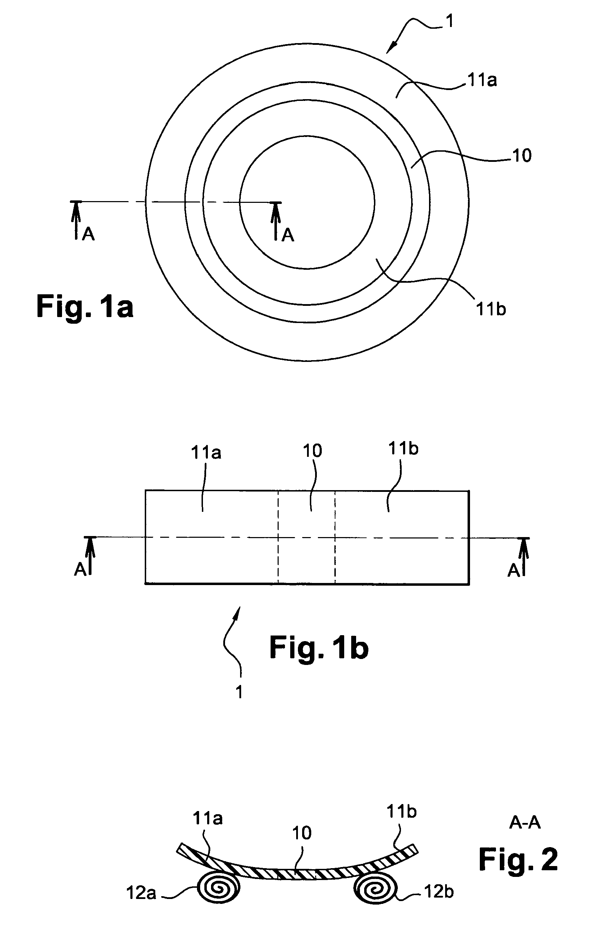

En référence aux figures 1a, 1b et 2, un joint métallique double lèvres pour assurer l'étanchéité entre deux éléments, nommés par la suite premier et deuxième éléments pour en faciliter la compréhension, comprend :
- un premier organe élastique **12a**, par exemple un ressort torique, destiné à être logé dans une première cavité du premier élément ;
- un deuxième organe élastique **12b**, par exemple un ressort torique, destiné à être logé dans une deuxième cavité du premier élément ; et
- un corps flexible **1** solidarisé au premier élément par une portion **10**, et comprenant :
   - une première extrémité libre **11a** formant une première lèvre, présentant une surface inférieure en contact avec le premier organe élastique **12a**, et une surface supérieure en regard de la surface inférieure destinée à être mise en contact avec le deuxième élément, et
   - une deuxième extrémité libre **11b** formant une deuxième lèvre, présentant une surface inférieure en contact avec le deuxième organe élastique **12b**, et une surface supérieure destinée à être mise en contact avec le deuxième élément.

Les premier et deuxième organes élastiques **12a**, **12b**, sont aptes à exercer une force de contact sur les première et deuxième extrémités **11a**, **11b** respectivement, pour assurer l'étanchéité.

Le corps flexible **1** peut être une lame métallique rectangulaire, comme illustré sur la figure 1b, ou de forme annulaire de type rondelle, comme illustré sur la figure 1a.

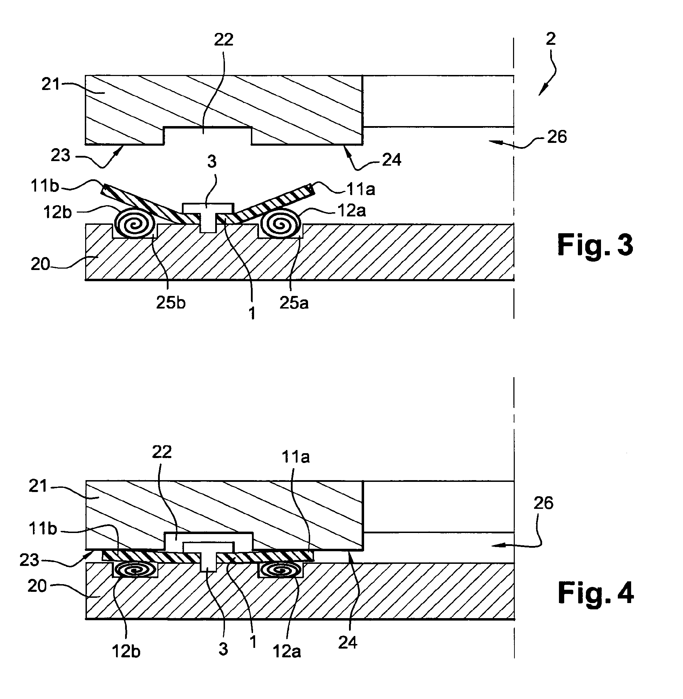

Le fonctionnement de ce joint va maintenant être explicité dans le cadre d'une installation telle que décrite dans le document US 5,968,389, en référence aux figures 3 et 4.

L'installation **2** ou dispositif d'hybridation comprend un bloc supérieur **21**, par exemple une cloche, comprenant une chambre intérieure **26** apte à recevoir un composant à hybrider sur une plaque support **20**, par exemple un substrat, à l'aide de microbilles de soudure, une chambre extérieure **22** en périphérie de la chambre intérieure **26** et séparée de la chambre intérieure **26** par une paroi interne **24** du bloc supérieur **21**, et une paroi externe **23** en périphérie de la chambre extérieure **22**.

La plaque support **20** est munie du joint double lèvres, le premier organe élastique **12a** étant logé dans une première cavité **25a** de la plaque support **20**, et le deuxième organe élastique **12b** étant logé dans une deuxième cavité **25b** de la plaque support **20**.

Le joint double lèvres est solidarisé à la plaque support **20** par un moyen de fixation **3** placé en regard de la chambre extérieure **22**. La première extrémité libre **11a** est placée en regard de la surface inférieure de la paroi interne **24**, et la deuxième extrémité libre **11b** est placée en regard de la paroi externe **23**.

Dans ce mode de réalisation, le joint permet d'assurer l'herméticité d'une première zone, ici la chambre extérieure **22**, mais également de créer une deuxième zone hermétique, ici la chambre intérieure **26**, entre les deux lèvres du joint. Par exemple, la chambre intérieure **26** est sous atmosphère contrôlée et la chambre extérieure **22** est sous vide.

La plaque support **20** est saisie et rendue solidaire du bloc supérieur **21** grâce au vide établi entre les deux lèvres. On pourra par exemple prévoir une vanne de commande du vide pour réaliser un vide dans la chambre extérieure **22**, et une vanne de commande d'un gaz pour introduire un gaz dans la chambre intérieure **26**, afin d'y ménager une atmosphère contrôlée.

Le joint double lèvres peut être implanté de la manière suivante :
- on découpe un corps flexible **1** dans une fine feuille de métal de sorte à obtenir par exemple une couronne métallique ;
- on perce le corps flexible **1** de trous de passage de vis sur un diamètre intermédiaire pour la fixation ultérieure sur la plaque support **20**, afin de rendre le corps flexible **1** démontable de la plaque support **20** ;
- on réalise deux ressorts parfaitement calibrés conçus pour appuyer par exemple sur la zone inférieure des deux extrémités diamétralement opposées de la couronne découpée ;
- on insert ces ressorts dans des gorges de maintien réalisées sur la plaque support ;
- on fixe le corps flexible sur la plaque support au moyen de vis et des trous de passage réalisés en son sein, les bords extérieurs diamétralement opposés du corps flexible se relevant de par les forces exercées par les ressorts.

Dans tous les cas, un évidemment peut être pratiqué sur le bloc supérieur **21** en regard du moyen de fixation **3**, quel que soit le moyen de fixation mis en oeuvre, que ce soit par soudure, collage ou fixation mécanique. Suivant le moyen de fixation, le joint peut bien entendu être démontable ou non démontable.

Le joint métallique à lèvre de l'invention trouve son application notamment dans les installations mettant en oeuvre des techniques de mise sous vide auto-entretenue d'une enceinte, par exemple dans les installations nécessitant à la fois l'établissement répété d'un vide poussé et d'une montée rapide à une température élevée, ou encore dans des installations permettant la soudure sous vide et à température élevée d'un capot par un joint.

Le joint métallique à lèvre de l'invention peut par exemple être utilisé dans les conditions suivantes :
- température minimum : 400°C
- durée d'exposition minimum à ladite température : 30 secondes répétées 1000 fois
- force d'appui maximum : 5 N/mm

L'invention permet ainsi de réaliser des installations pouvant assurer des fonctionnements sous vide à très haute température. L'invention peut être mise en oeuvre par exemple pour une chambre d'assemblage de machine de soudure sous vide nécessitant une montée en température supérieure à 320°C, pour une chambre de machine de gravure plasma sous vide, ou pour machine de dépôt de couches métalliques sous vide, ou tout autre type de machine nécessitant un joint résistant à haute température avec l'exigence d'une force d'appui limitée sur le joint. La force d'appui peut par exemple être nettement inférieure à 60N/mm, valeur au dessus de laquelle un joint métallique de l'art antérieur suffit.

Elle s'applique notamment au domaine des dispositifs de réalisation de vide poussé, outre à celui plus spécifique de la réalisation de cordon de soudure lors de la réalisation de composants électroniques ou opto-électroniques.

## Revendications

1. Dispositif de joint métallique à lèvres apte à assurer l'étanchéité entre deux éléments (20, 21), comprenant :
- deux organes élastiques (12a, 12b) destinés à être logés chacun dans une cavité (25a, 25b) de l'un (20) des deux éléments, lesdites cavités (25a, 25b) étant situées à l'aplomb d'une zone de coopération des deux éléments entre eux au niveau de laquelle l'étanchéité est recherchée ;
- un élément (20) recevant lesdits organes élastiques ; et
- un corps flexible (1) solidarisé à l'élément (20) recevant les organes élastiques (12a, 12b), pourvu de deux extrémités libres (11a, 11b), lesdites extrémités libres s'étendant au moins à l'aplomb desdites zones de coopération et étant en contact avec les organes élastiques (12a, 12b) ;
chacun des organes élastiques (12a, 12b) étant apte à exercer une force de contact sur les extrémités libres (11a, 11b) pour assurer une étanchéité entre les deux éléments.

2. Dispositif de joint à lèvre selon la revendication 1, ***caractérisé* en ce que** les organes élastiques (12a, 12b) sont des ressorts toriques.

3. Dispositif de joint à lèvre selon l'une des revendications 1 et 2, ***caractérisé* en ce que** le corps flexible (1) est constitué d'une lame métallique de forme rectangulaire.

4. Dispositif de joint à lèvre selon l'une des revendications 1 et 2, ***caractérisé* en ce que** le corps flexible (1) est constitué d'une couronne annulaire, typiquement une rondelle percée en son centre.

5. Dispositif de joint à lèvre selon l'une des revendications 1 à 4, ***caractérisé* en ce que** la solidarisation du corps flexible (1) à l'élément (20) est réalisée par collage, soudure ou vissage.

6. Dispositif d'hybridation (2) de composants par billes de soudure comprenant au moins:
- un bloc supérieur (21) comprenant une chambre intérieure (26) apte à recevoir un composant à hybrider sur une plaque support (20), et notamment un substrat, à l'aide de microbilles de soudure, et une chambre extérieure (22) en périphérie de la chambre intérieure (26) et séparée de la chambre intérieure (26) par une paroi interne (24) au bloc supérieur (21), et une paroi externe (23) en périphérie de la chambre extérieure (22) ;
- des moyens pour amener la plaque support (20) en contact thermique avec un élément chauffant, après que l'élément chauffant ait atteint une certaine température de fusion ;
- des moyens pour découpler la plaque support (20) de l'élément chauffant, après chauffage du substrat ;
le dispositif d'hybridation étant muni d'un dispositif joint selon l'une des revendications 1 à 5, l'élément (20) recevant lesdits organes élastiques (12a, 12b) constituant ladite plaque support (20), les organes élastiques (12a, 12b) dudit joint étant logé dans une cavité (25a, 25b) de ladite plaque support (20), la portion (10) du corps flexible (1) solidarisée à la plaque support (20) étant en regard de la chambre extérieure (22), et lesdites extrémités libres (11a, 11b) du joint étant en regard respectivement de la paroi interne (24) et de la paroi externe (23) au niveau desquelles l'étanchéité est recherchée.

7. Dispositif selon la revendication 6, ***caractérisé* en ce que** lesdites extrémités libres (11a, 11b) subissent une force d'appui de la paroi interne (24) et de la paroi externe (23) respectivement inférieure à 60 Newtons par millimètre linéaire de joint, ladite force d'appui résultant au moins d'une différence de pression entre les chambres intérieure et extérieure (26, 22) et entre la chambre extérieure (22) et l'environnement dans lequel se trouve ledit dispositif, respectivement.

8. Dispositif selon l'une des revendications 6 et 7, ***caractérisé* en ce que** la chambre intérieure (26) est sous vide.

9. Dispositif selon l'une des revendications 7 et 8, ***caractérisé* en ce que** la chambre intérieure (26) est sous atmosphère contrôlée et **en ce que** la chambre extérieure (22) est sous vide.

## Claims

1. Device with metal lip seal capable of ensuring tightness between two elements (20, 21), including :
- two resilient members (12a, 12b) each intended to be accommodated in a cavity (25a, 25b) of one (20) of the two elements, said cavities (25a, 25b) being located in line with a zone of engagement of the two elements one with the other in which said tightness is desired;
- an element (20) receiving said resilient members, and
- a flexible body (1) secured to the element (20) receiving the resilient members (12a, 12b), provided with two free ends (11a, 11b), said free ends extending at least in line with said engagement zones and being in contact with the resilient members (12a, 12b);
each of the resilient members (12a, 12b) being capable of exerting a contact force on the free ends (11a, 11b) to ensure tightness between the two elements.

2. Device with lip seal as claimed in claim 1, ***characterized* in that** the resilient members (12a, 12b) are ring-shaped springs.

3. Device with lip seal as claimed in one of claims 1 and 2, ***characterized* in that** the flexible body (1) is constituted by a metal blade of rectangular shape.

4. Device with lip seal as claimed in one of claims 1 and 2, ***characterized* in that** the flexible body (1) is constituted by an annular ring, typically a washer pierced at its center.

5. Device with lip seal as claimed in one of claims 1 to 4, ***characterized* in that** the flexible body (1) is secured to the element (20) by bonding, welding or screwing.

6. Device for the hybridization (2) of components by weld beads including at least:
- an upper block (21) including an internal chamber (26) capable of receiving a component for hybridization on a support plate (20), and particularly a substrate, by means of weld micro-beads, and an external chamber (22) on the periphery of the internal chamber (26) and separated from the internal chamber (26) by a wall (24) internal to the upper block (21), and an external wall (23) on the periphery of the external chamber (22) ;
- means for bringing the support plate (20) into thermal contact with a heating element, after the heating element has reached a certain fusion temperature;
- means for uncoupling the support plate (20) from the heating element, after the substrate is heated;
said hybridization device being provided with a device with a seal as claimed in one of claims 1 to 5, the element (20) receiving the resilient members (12a, 12b) defining said support plate (20), the resilient members (12a, 12b) of said seal being accommodated in a cavity (25a, 25b) of said support plate (20), the portion (10) of the flexible body (1) secured to the support plate (20) being opposite the external chamber (22), and said free ends (11a, 11b) of the seal being opposite the internal wall (24) and the external wall (23) respectively at which point tightness is desired.

7. Device as claimed in claim 6, ***characterized* in that** said free ends (11a, 11b) are subjected to a bearing force of the internal wall (24) and the external wall (23) respectively less than 60 newtons per linear millimeter of seal, said bearing force resulting at least from a pressure difference between the internal and external chambers (26, 22) and between the external chamber (22) and the environment in which said device is placed, respectively.

8. Device as claimed in one of claims 6 and 7, ***characterized* in that** the internal chamber (26) is under vacuum.

9. Device as claimed in one of claims 7 and 8, ***characterized* in that** the internal chamber (26) is under a controlled atmosphere and **in that** the external chamber (22) is under vacuum.

## Patentansprüche

1. Lippendichtungsvorrichtung aus Metall, die die Dichtigkeit zwischen zwei Bauteilen (20, 21) sicherstellen kann, Folgendes umfassend:
- zwei elastische Teile (12a, 12b), die dazu bestimmt sind, jeweils in einem Hohlraum (25a, 25b) eines (20) der beiden Bauteile untergebracht zu sein, wobei sich die Hohlräume (25a, 25b) in der Senkrechten eines Bereichs des Zusammenwirkens der beiden Bauteile befinden, in dem die Dichtigkeit angestrebt wird;
- wobei ein Bauteil (20) die elastischen Teile aufnimmt; und
- einen mit dem Bauteil (20), das die elastischen Teile (12a, 12b) aufnimmt, fest verbundenen flexiblen Körper (1), der mit zwei freien Enden (11a, 11b) versehen ist, wobei sich die freien Enden zumindest bis zur Senkrechten der Zusammenwirkungsbereiche erstrecken und mit den elastischen Teilen (12a, 12b) in Kontakt sind;
wobei jedes der elastischen Teile (12a, 12b) eine Kontaktkraft auf die freien Enden (11a, 11b) ausüben kann, um eine Dichtigkeit zwischen den beiden Bauteilen sicherzustellen.

2. Lippendichtungsvorrichtung nach Anspruch 1, **dadurch gekennzeichnet, dass** die elastischen Teile (12a, 12b) torische Federn sind.

3. Lippendichtungsvorrichtung nach einem der Ansprüche 1 und 2, **dadurch gekennzeichnet, dass** der flexible Körper (1) aus einem rechteckförmigen Metallstreifen besteht.

4. Lippendichtungsvorrichtung nach einem der Ansprüche 1 und 2, **dadurch gekennzeichnet, dass** der flexible Körper (1) aus einem Ringkranz, typischerweise einer in ihrer Mitte durchbrochenen runden Scheibe besteht.

5. Lippendichtungsvorrichtung nach einem der Ansprüche 1 bis 4, **dadurch gekennzeichnet, dass** die Befestigung des flexiblen Körpers (1) am Bauteil (20) durch Verkleben, Verschmelzen oder Verschrauben hergestellt ist.

6. Vorrichtung (2) zur Hybridierung von Bauelementen durch Lötkugeln, mindestens Folgendes umfassend.
- einen oberen Block (21), der eine Innenkammer (26), die ein zu hybridierendes Bauelement auf einer Halterungsplatte (20) und insbesondere einem Substrat mit Hilfe von Mikrolötkugeln aufnehmen kann, und am Umfang der Innenkammer (26) eine Außenkammer (22) umfasst, die von der Innenkammer (26) durch eine im oberen Block (21) innenliegende Wand (24) und eine außenliegende Wand (23) am Umfang der Außenkammer (22) getrennt ist;
- Einrichtungen, um die Halterungsplatte (20) in Wärmekontakt mit einem Heizelement zu bringen, nachdem das Heizelement eine bestimmte Schmelztemperatur erreicht hat;
- Einrichtungen zum Abkoppeln der Halterungsplatte (20) vom Heizelement nach Erwärmung des Substrats;
wobei die Hybridierungsvorrichtung mit einer Dichtungsvorrichtung nach einem der Ansprüche 1 bis 5 versehen ist, wobei das Element (20), das die elastischen Teile (12a, 12b) aufnimmt, die Halterungsplatte (20) bildet, wobei die elastischen Teile (12a, 12b) der Dichtung in einem Hohlraum (25a, 25b) der Halterungsplatte (20) untergebracht sind, wobei der an der Halterungsplatte (20) befestigte Abschnitt (10) des flexiblen Körpers (1) der Außenkammer (22) zugewandt ist, und die freien Enden (11a, 11b) der Dichtung der innenliegenden Wand (24) bzw. der außenliegenden Wand (23) zugewandt sind, in deren Bereich die Dichtigkeit angestrebt wird.

7. Vorrichtung nach Anspruch 6, **dadurch gekennzeichnet, dass** die freien Enden (11a, 11b) eine Stützkraft der innenliegenden Wand (24) und der außenliegenden Wand (23) von jeweils unter 60 Newton pro linearem Millimeter der Dichtung erfahren, wobei sich diese Stützkraft aus zumindest einem Druckunterschied zwischen der Innen- und Außenkammer (26, 22) bzw. zwischen der Außenkammer (22) und dem Umfeld ergibt, in dem sich die Vorrichtung befindet.

8. Vorrichtung nach einem der Ansprüche 6 und 7, **dadurch gekennzeichnet, dass** die Innenkammer (26) unter Vakuum steht.

9. Vorrichtung nach einem der Ansprüche 7 und 8, **dadurch gekennzeichnet, dass** die Innenkammer (26) unter gesteuerter Atmosphäre steht, und dass die Außenkammer (22) unter Vakuum steht.
